# EUROPÄISCHE PATENTSCHRIFT

(11) **EP 0 386 824 B1**
(45) Veröffentlichungstag und Bekanntmachung des Hinweises auf die Patenterteilung: **04.05.1994**
(21) Anmeldenummer: 90200460.5
(22) Anmeldetag: 27.02.1990
(51) Int. Cl.: G01R 33/022

(54) **Supraleitendes Gradiometer zur Messung schwacher Magnetfelder und ein Verfahren zu seiner Herstellung**
Superconductive gradiometer for weak magnetic-field measurement, and method of producing same
Gradiomètre supraconducteur pour mesurer des champs magnétiques faibles et son procédé de fabrication

(30) Priorität: 04.03.1989 DE 3906981
(43) Veröffentlichungstag der Anmeldung: 12.09.1990
(73) Patentinhaber: Philips Patentverwaltung GmbH, 22335 Hamburg (DE); Philips Electronics N.V., 5621 BA Eindhoven (NL)
(72) Erfinder: Dössel, Olaf, Dr., D-2081 Tangstedt (DE); Edeler, Wilfried, D-2000 Hamburg 53 (DE)
(74) Vertreter: Kupfermann, Fritz-Joachim, Dipl.-Ing.

(56) Entgegenhaltungen:
- EP-A- 0 184 670
- EP-A- 0 257 342
- US-A- 4 280 095
- CRYOGENICS, Band 27, Nr. 9, 1987, Seiten 503-504, Guildford, GB; D. HECHTFISCHER: "Generation of homogeneous magnetic fields within closed suprconductive shields"
- PATENT ABSTRACTS OF JAPAN, Band 13, Nr. 980 (P-952)[3828], 31. Oktober 1989; & JP-A-1 191 079 (MITSUBISHI) 01-08-1989

## Beschreibung

Die Erfindung betrifft ein supraleitendes Gradiometer zur Messung schwacher Magnefrelder für eine Meßvorrichtung mit einer mit einem Gradiometer verbundenen Einkoppelspule und einem SQUID in einem Kryosystem und einer Auswertevorrichtung, und ein Verfahren zur Herstellung des Gradiometers zur Messung schwacher Magnetfelder für eine Meßvorrichtung mit einer mit dem Gradiometer verbundenen Einkoppelspule und einem SQUID in einem Kryosystem und einer Auswertevorrichtung.

Zur Messung schwacher Magnetfelder in einem Feldstärkebereich von unter 10⁻¹⁰ T werden supraleitende Quanten-Interferenz-Detektoren, SQUID's (Superconducting Quantum Interference Devices) verwendet. Sie dienen als Meßsensoren z.B. in der Medizintechnik zur Messung der Magnetfelder des Herzens (Magnetokardiographie) oder des Gehirns (Magnetoenzephalographie) oder auch zur Leberdiagnostik (Lebersuszeptometrie). Eine entsprechende Meßvorrichtung für diese schwachen Magnetfelder enthält neben einem SQUID ein Gradiometer, eine Einkoppelspule und eine Auswerteeinrichtung. Das Gradiometer, die Einkoppelspule und das SQUID sind zusammen in einem Kryosystem, welches die Temperatur zur Erreichung der Supraleitung erzeugt, angeordnet. Das Gradiometer trägt eine Spule, die das zu messende Magnetfeld erfaßt und mit der Einkoppelspule einen geschlossenen supraleitenden Stromkreis bildet. Mit der Einkoppelspule wird das gemessene Magnetfeld in das SQUID transformiert.

Die Gradiometer dienen im wesentlichen dazu, das Meßsystem gegenüber homogenen Magnetfeldern weitgehend unempfindlich zu machen. So gelingt es, mit Gradiometern inhomogene Felder zu messen, die um viele Größenordnungen kleiner als das homogene Magnetfeld der Erde sind. Durch Gradiometer höherer Ordnung können weiterhin störende Signale von weiter entfernten Quellen gegenüber solchen, die von nahegelegenen Quellen kommen, unterdrückt werden. Die Qualität eines Gradiometers hängt entscheidend davon ab, wie gut es gelingt, es gegenüber unerwünschten Feldkomponenten oder Gradienten unempfindlich zu machen. Dabei soll durch die Messung des Gradienten anstelle des eigentlichen Feldes keine wesentliche Information über die Quelle des Magnetfeldes verlorengehen. Zur Vermessung der z-Komponente eines inhomogenen Feldes können z.B. die Gradienten in drei Raumrichtungen dB_{z}/dz, dB_{z}/dx, dB_{z}/dy herangezogen werden. Der Gradient in z-Richtung erfordert gegenüber gemischten Gradienten eine dreidimensionale Spulenanordnung. Ein Gradiometer für dB_{z}/dz ist abgeglichen, wenn es hinsichtlich der Feldkomponenten Bₓ, B_{y} und B_{z} und der Feldgradienten dB_{z}/dy und dB_{z}/dx unempfindlich ist. Ein Maß für den Abgleich bezüglich der drei Feldkomponenten ist der Quotient aus der angezeigten scheinbaren Felddifferenz in z-Richtung und der Stärke des jeweils anliegenden homogenen Feldes ΔB_{z}/B_{z}, ΔB_{z}/Bₓ, ΔB_{z}/B_{y}. Für biomagnetische Anwendungen werden Abgleichwerte besser als 10⁻⁴ angestrebt.

Für derartige Anwendungen sind im Stand der Technik Gradiometer mit mindestens einer Windung aus Draht bekannt. Diese Gradiometer weisen zumeist einen Trägerkörper mit sehr präzisen Einkerbungen auf, welche den Draht aufnehmen. Trotz des sehr genau eingelegten und in den Einkerbungen festgeklebten Drahtes mit einem typischen Durchmesser von ca. 0,1 mm, sind diese Gradiometer nur auf etwa 1 % abzugleichen, da sich der Draht u.a. in den Knickpunkten bei den Verbindungsleitungen nicht präzise genug einlegen läßt und aufgrund der nicht vollkommen übereinstimmenden thermischen Ausdehnungskoeffizienten der verwendeten Materialien und der großen Temperaturunterschiede zwischen Herstellung und Betrieb nicht präzise genug gehalten werden kann. Blickt man aus der x-Richtung auf ein solches Gradiometer dB_{z}/dz und erkennt eine kleine, von Draht umschlossene Fläche, weil z.B. zwei Windungen nicht parallel verlaufen, dann resultiert hieraus ein Fehlabgleich Δ B_{z}/Bₓ. Erkennt man aus der z-Richtung eines solchen Gradiometers eine von Draht umschlossene Fläche in einer Windung, die nicht vollständig von einer anderen Windung überdeckt ist, so verursacht dies dann einen Fehlabgleich Δ B_{z}/B_{z}. Ferner sind Techniken bekannt, nachträglich einen Gradiometerabgleich mit Hilfe von supraleitenden und normalleitenden Plättchen durchzuführen, die jedoch für mehrkanalige, nebeneinander angeordnete Gradiometer ungeeignet sind, da der Abgleich eines Kanals zum Fehlabgleich der benachbarten Kanäle führt.

Diese Abgleichprobleme haben zu Dünnfilm-Gradiometern geführt, welche in der Regel weiter den Vorteil bieten, daß sie mit Hilfe eines Lasers nachträglich noch genauer abgeglichen werden können, und daß der so erzielte Abgleich auch nach mehreren thermischen Zyklen erhalten bleibt. Der gewünschte Abgleichwert von 10⁻⁴ wird dabei gleich nach der Herstellung erreicht. Derartige bekannte planare Anordnungen sind wegen des damit realisierbaren gemischten Gradienten im Bereich des Biomagnetismus vermutlich nicht verwendbar, da sie die für eine Rekonstruktion neuronaler Quellen nötige Information über das Feld nicht liefern. Entsprechende dreidimensionale, auf Methoden der Dünnfilmtechnologie basierende, für mehrkanalige Meßsysteme geeignete Gradiometer dB_{z}/dz gehen beispielsweise aus den europäischen Patentanmeldungen 0 184 670, 0 185 186 und 0 111 827 sowie aus der US-PS 42 80 095 als bekannt hervor.

In den beiden erstgenannten europäischen Patentanmeldungen wird vorgeschlagen, die Spulenwindungen mit Hilfe der Dünnfilmtechnologie auf eine flexible Folie aufzubringen und nachträglich in die gewünschte dreidimensionale Form zu bringen. Hierbei ist allerdings zu befürchten, daß nun die flexible Folie nicht präzise genug verklebt werden kann, und durch den großen thermischen Ausdehnungskoeffizient von Klebematerialien beim Abkühlen nicht maßhaltig bleibt. In der dritten europäischen Patentanmeldung wird ein Verfahren beschrieben, mit dem eine Dünnfilmbahn um die Kante eines Würfels herum hergestellt werden kann, so daß ein dreidimensional geformtes Gradiometer auf den Seitenflächen eines Würfels entsteht. Hierbei ist zu bedenken, daß eine Strukturierung auf nichtstandardisierten Substraten (Siliziumscheiben) außerordentlich schwierig ist. Das zuletzt genannte US-Patent betrifft ein als Doppelspirale aufgebautes, extrem empfindliches SQUID. Supraleitende Windungen werden dabei in Dünnfilmtechnik in Rillen der Mantelfläche eines nichtleitenden Trägerkörpers gebildet, ebenso wie die Josephson-Kontakte eines SQUIDs selbst. Um u.a. ein kontaktfreies Kreuzen mehrerer Windungen zu ermöglichen, ist ein aufwendiges mehrfaches Beschichten mit supraleitendem Dünnfilm und nichtleitendem Material erforderlich. Hinsichtlich des gewünschten Abgleiches müssen diese Beschichtungsvorgänge sehr präzise ausgeführt werden und sind somit technisch sehr aufwendig. Ein nachträglicher Feinabgleich ist nicht möglich.

Der vorliegenden Erfindung liegt die Aufgabe zugrunde, ein supraleitendes Gradiometer zur Messung schwacher Magnetfelder zu schaffen, bei dem die ungenaue Lage eines Gradiometerdrahtes keinen Fehlabgleich verursacht und Fehlerquellen, wie z.B. die temperaturabhängige Lageveränderung des Drahtes, keinen Einfluß auf den Abgleich haben, sowie Herstellungsverfahren für ein solches Gradiometer anzugeben, dessen Abgleich nach seiner Herstellung bereits besser als 10⁻⁴ ist.

Zur Lösung dieser Aufgabe wird ein supraleitendes Gradiometer vorgeschlagen, bei dem das Gradiometer einen nichtmagnetischen Trägerkörper mit einer Mantelfläche aufweist, die mit mindestens einer umlaufenden Nut und mindestens einer daran angrenzenden, axial ausgerichteten Nut versehen ist, daß jede Nut einen supraleitenden Dünnfilm trägt und die umlaufende Nut mindestens eine supraleitende Drahtwindung und die axial ausgerichtete Nut eine supraleitende Verbindungsleitung vollständig und elektrisch kontaktfrei aufnimmt, und daß der umlaufende Dünnfilm unterbrochen ist; ferner wird ein Verfahren zur Herstellung eines solchen supraleitenden Gradiometers mit den Merkmalen vorgeschlagen, daß in die Mantelfläche eines nicht metallischen Trägerkörpers mindestens eine genau bemessene, umlaufende Nut und orthogonal dazu mindestens eine weitere Nut eingeschnitten wird, daß die Mantelfläche und jede Nut ganzflächig mit einem supraleitenden Dünnfilm beschichtet wird, daß der supraleitende Dünnfilm auf der Mantelfläche und im Bereich eines Spaltes in jeder umlaufenden Nut entfernt und anschließend ein isolierter supraleitender, mindestens eine Windung je umlaufende Nut aufweisender Draht in die Nuten eingelegt und darin befestigt wird; ferner ein weiteres Verfahren mit den Merkmalen vorgeschlagen, daß auf die Mantelfläche eines nicht metallischen Trägerkörpers eine Lackschicht aufgetragen wird und anschließend mindestens eine genau bemessene, umlaufende Nut und orthogonal dazu mindestens eine weitere Nut in die Mantelfläche geschnitten wird, daß die Mantelfläche und jede Nut ganzflächig mit einem supraleitenden Dünnfilm beschichtet wird, daß der supraleitende Dünnfilm auf der belackten Mantelfläche durch Eintauchen in ein Lösungsmittel für den Lack in jeder umlaufenden Nut entfernt wird, daß der supraleitende Dünnfilm im Bereich eines Spaltes in jeder umlaufenden Nut entfernt wird und anschließend ein isolierter supraleitender, mindestens eine Windung aufweisender Draht in die Nuten eingelegt und darin befestigt wird.

Das erfindungsgemäße supraleitende Gradiometer ist teils unter Zuhilfenahme der Dünnfilmtechnologie und teils mit einem supraleitenden Draht verwirklicht. Hierdurch ist es möglich, den für Dünnfilmgradiometer typischen hervorragenden Abgleich zu erzielen. Als Trägerkörper wird ein nichtmagnetisches zylindrisches Substrat verwendet. Die Mantelfläche des Trägerkörpers weist vorteilhaft V-förmige, teilweise um den Trägerkörper herum und teilweise senkrecht dazu angeordnete Nuten auf. Die Nuten, also mindestens eine umlaufende und eine orthogonal dazu verlaufende Nut, tragen einen supraleitenden Dünnfilm, der in den kreisförmigen umlaufenden Nuten jeweils durch einen schmalen Spalt unterbrochen ist, so daß keine in sich geschlossenen supraleitenden Kreise entstehen. In den Nuten befindet sich ein supraleitender isolierter Draht. Der Draht wird dabei vollständig von jeder Nut aufgenommen. In der der Verbindung dienenden, nicht umlaufenden Nut kann der Draht verdrillt angeordnet sein. Sind mehrere Ebenen von Drahtwindungen vorgesehen, dann sind diese in einer Reihenschaltung geschaltet. Der dem zu untersuchenden Substrat am nächsten liegenden Windung sind dann weitere Windungen teilweise mit umgekehrtem Wickelsinn nachgeschaltet und diesen kann dann eine weitere Windung folgen, die dann den gleichen Wickelsinn wie die erste Windung aufweist. Die dem zu untersuchenden Objekt zugewandte Windung stellt die Detektionsspule dar, während die übrigen Spulen dann als Kompensationsspulen wirken. Ein solches supraleitendes Gradiometer hat einen Abgleich von besser als 10⁻⁴.

Derartige erfindungsgemäße Gradiometer lassen sich ferner zu mehrkanaligen Meßvorrichtungen zusammenfassen.

Weitere bevorzugte Ausgestaltungen des supraleitenden Gradiometers ergeben sich aus den Patentansprüchen 2 bis 5.

Ein erfindungsgemäßes Verfahren zur Herstellung eines solchen supraleitenden Gradiometers erfolgt in besonders einfacher Weise dadurch, daß in die Mantelfläche eines zylindrischen nichtmagnetischen Trägerkörpers Nuten geschnitten werden. Die Nuten verlaufen teilweise kreisförmig um den Träger herum, um die kreisförmigen Windungen aufzunehmen. Teilweise sind sie senkrecht dazu angeordnet, um die Verbindungsleitungen zwischen den einzelnen Spulenwindungen aufzunehmen. Die Nuten sind vorteilhaft V-förmig ausgebildet und so tief, daß der supraleitende Draht vollständig darin Platz findet. Anschließend wird die Mantelfläche des Trägerkörpers, auf der sich auch die Nuten befinden, ganzflächig mit einem supraleitenden Dünnfilm beschichtet. Hierzu können bekannte Beschichtungsverfahren eingesetzt werden. Mit beispielsweise einer Poliereinrichtung wird anschließend der supraleitende Dünnfilm auf der Mantelfläche des Trägerkörpers entfernt, so daß der Dünnfilm nur in den Nuten stehen bleibt. Der Dünnfilm wird dann in den kreisförmigen umlaufenden Nuten auf einem sehr schmalen Spalt einmal unterbrochen, so daß keine in sich geschlossenen supraleitenden Kreise übrigbleiben. Beispielsweise kann dies mit einem Trim-Laser erfolgen. Schließlich wird der isolierte supraleitende Draht in die Nuten eingelegt und dort befestigt. In den längeren, senkrecht verlaufenden Verbindungsnuten werden die beiden supraleitenden Drähte vorteilhaft verdrillt.

Ein weiteres erfindungsgemäßes Verfahren zur Herstellung eines erfindungsgemäßen supraleitenden Gradiometers erfolgt in einfacher Weise dadurch, daß zunächst auf die Mantelfläche eines zylindrischen Trägerkörpers eine dünne Lackschicht aufgebracht wird, wie sie z.B. bei der Photolithographie verwendet wird. Erst, nachdem die Lackschicht aufgebracht worden ist, erfolgt wie bei dem eingangs beschriebenen Verfahren das Schneiden der Nuten und ein ganzflächiges Beschichten mit einem supraleitenden Dünnfilm. Daran anschließend wird der Trägerkörper in eine Flüssigkeit getaucht, die den unter der supraleitenden Beschichtung befindlichen Lack auflöst, so daß sich der supraleitende Dünnfilm nur auf den Mantelflächen des Trägerkörpers ablöst, nicht aber in den Nuten. Der Dünnfilm wird dann noch in den kreisförmigen umlaufenden Nuten auf einem sehr schmalen Spalt einmal unterbrochen, so daß keine in sich geschlossenen supraleitenden Kreise verbleiben. Etwa wie beim vorgenannten Verfahren kann dies beispielsweise mit einem Trim-Laser erfolgen. Wie bei dem vorgenannten Verfahren wird dann der isolierte supraleitende Draht in die Nuten eingelegt und dort befestigt.

Weitere bevorzugte Verfahrensschritte zur Herstellung eines entsprechenden supraleitenden Gradiometers ergeben sich aus den Patentansprüchen 8 bis 13.

Mit dem vorgenannten erfindungsgemäßen Verfahren entsteht ein supraleitendes Gradiometer nach der Erfindung, bei dem der zu messende magnetische Fluß im wesentlichen von dem supraleitenden Dünnfilm geführt wird. Magnetische Felder können einen Supraleiter nicht durchdringen und müssen daher um den Dünnfilm in den Nuten herumgeführt werden. Da die Nuten den Draht weitgehend umschließen, wird der resultierende Feldverlauf durch die Lage und Anordnung der Nuten und nicht durch die Lage des Drahtes bestimmt. Die Nuten jedoch können ohne besonderen Aufwand sehr präzise geschnitten werden und bleiben darüber hinaus beim Abkühlen maßhaltig, wodurch sich bereits beim Herstellen der gewünschte Abgleich ergibt. In den senkrecht verlaufenden Verbindungsnuten verhindert der Dünnfilm ein Eindringen des magnetischen Flusses zwischen die verdrillten Drähte. So ergibt sich dann ein Abgleich des Gradiometers besser als 10⁻⁴ gleich nach der Herstellung und ohne weitere Abgleichprozeduren. Durch die Abschirmung der verdrillten Verbindungsleitungen verringert sich darüber hinaus die störende Induktivität dieser Leitungen. Da der Draht vollständig innerhalb der Nuten verläuft, kann ein geringfügiges Verändern seiner Lage, durch z.B. Temperatureinflüsse, keinen Einfluß auf den Abgleich haben. Sollte ein nachträglicher Feinabgleich nötig sein, so ist auch dies möglich, indem die supraleitenden Flächen in den Nuten nachträglich mit einem Trim-Laser eingeschnitten werden.

Ein Ausführungsbeispiel der Erfindung wird nachfolgend unter Bezugnahme auf eine Zeichnung näher erläutert. Es zeigt:
Fig. 1 einen nichtmagnetischen zylindrischen Trägerkörper eines Gradiometers mit zwei umlaufenden Nuten und einer orthogonal dazu verlaufenden Nut,
Fig. 2 einen supraleitenden isolierten Draht mit einer Windung,
Fig. 3 einen supraleitenden isolierten Draht mit zwei Windungen mit unterschiedlichem Wickelsinn und verdrillten Zuleitungen für den Trägerkörper nach Fig. 1, und
Fig. 4 einen supraleitenden isolierten Draht mit mehreren Windungen, wobei zwei mittlere Windungen gegenüber den äußeren entgegengesetzten Wickelsinn aufweisen.

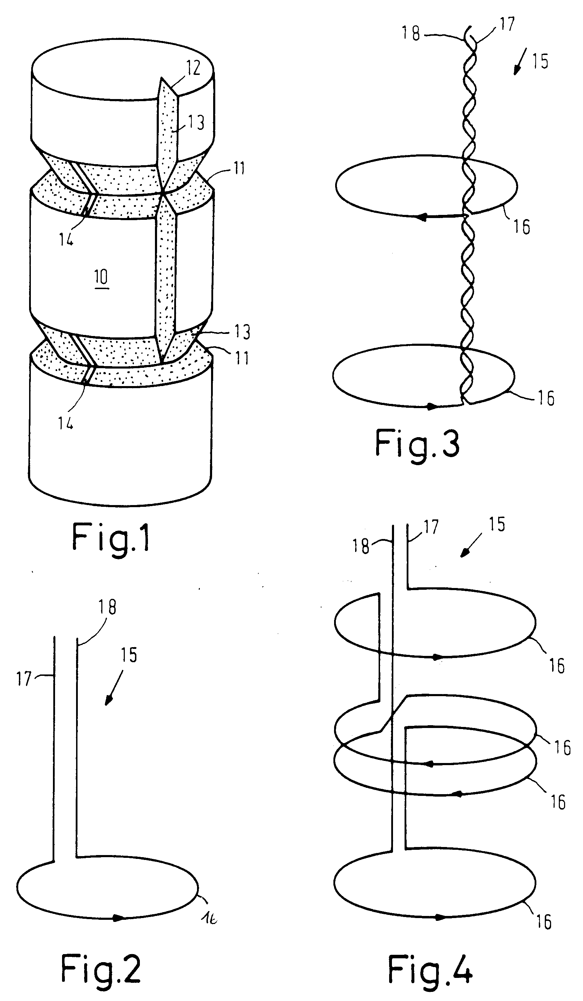

Fig. 1 zeigt einen nichtmagnetischen zylindrischen Trägerkörper 10, z.B. aus einer bearbeitbaren Keramik. In den Trägerkörper 10 sind zwei umlaufende Nuten 11 und eine dazu orthogonal ausgerichtete Nut 12 geschnitten, die der Verbindung der umlaufenden Nuten 11 untereinander und mit einer nicht dargestellten Einkoppelspule dient. Die Nut 12 ist axial ausgerichtet und auf der Mantelfläche des Trägerkörpers 10 angeordnet. Jede Nut 11, 12 weist erfindungsgemäß einen Dünnfilm 13 auf ihrer Oberfläche auf. Es handelt sich hierbei um einen supraleitenden Dünnfilm 13, der mit einem bekannten Beschichtungsverfahren, wie z.B. der Elektronenstrahlverdampfung oder Hochfrequenzzerstäubung, zunächst auch auf die Mantelfläche des Trägerkörpers 10 aufgebracht wurde, dort jedoch beispielsweise mit einer Poliereinrichtung wieder entfernt wurde, so daß nur in jeder Nut 11, 12 der supraleitende Dünnfilm 13 stehen bleibt. Der supraleitende Dünnfilm 13 ist in jeder umlaufenden Nut 11 einmal durch einen schmalen Spalt 14 unterbrochen, so daß dort keine in sich geschlossenen supraleitende Kreise übrigbleiben. Diese Spalte 14 können beispielsweise mit einem Trim-Laser in den umlaufenden Nuten 11 erzeugt werden.

Der Trägerkörper 10 des erfindungsgemäßen Gradiometers kann auch dadurch hergestellt werden, daß auf die Mantelfläche des zylindrischen Trägerkörpers 10 eine nicht dargestellte dünne Lackschicht aufgebracht wird, wie sie z.B. bei der Photolithographie verwendet wird. Danach werden dann die Nuten 11 und 12 geschnitten und die Mantelfläche vollständig mit einem supraleitenden Dünnfilm 13 in der beschriebenen Weise beschichtet. Anschließend kann der Träger dann in eine Lösungsflüssigkeit für den Lack gelegt werden, so daß der supraleitende Dünnfilm 13 nur in den Nuten 11, 12 verbleibt. Der supraleitende Dünnfilm 13 ist dann noch in jeder umlaufenden Nut 11 einmal durch einen schmalen Spalt 14 zu unterbrechen. Dies kann ebenfalls mit einem Trim-Laser durchgeführt werden.

Vorteilhaft weist jede Nut 11, 12 einen V-förmigen Querschnitt auf und ist so tief in den Trägerkörper 10 geschnitten, daß ein supraleitender Draht 15 (Fig. 3) vollständig darin versenkt werden kann. Als supraleitender Dünnfilm 13 kann beispielsweise Niob oder Niobnitrid verwendet werden. Der supraleitende Draht 15, der entsprechend Fig. 3 in zwei Windungen gelegt ist, findet in den Nuten 11, 12 Platz und ist dort befestigt, z.B. verklebt. Der Draht kann dabei einen typischen Durchmesser von 0,1 mm aufweisen.

Nachdem der supraleitende Draht 15, der überdies isoliert ist, in den Nuten 11, 12 verankert ist, entsteht ein erfindungsgemäßes Gradiometer, bei dem der zu messende magnetische Fluß im wesentlichen von dem supraleitenden Dünnfilm in den Nuten 11, 12 geführt wird. Die Nuten 11, 12 können auf einfache Weise sehr präzise geschnitten werden, wodurch sich bereits nach der Herstellung ein gewünschter Abgleich von besser als 10⁻⁴ ergibt. Dies deshalb, weil magnetische Felder einen Supraleiter nicht durchdringen können und daher um den Dünnfilm in den Nuten 11, 12 herumgeführt wird, wodurch der resultierende Feidverlauf allein von den Nuten 11, 12 bestimmt wird. Abgleichfehler durch den Draht 15 in der Verbindungsnut 12 werden ebenfalls durch den Dünnfilm 13 in dieser Nut 12 verhindert. Durch diese Abschirmung des verdrillten Drahtes 15 verringert sich darüber hinaus die störende Induktivität dieser Leitungen. Das erfindungsgemäße Gradiometer ist darüber hinaus auch für einen nachträglichen Feinabgleich besonders gut geeignet, da die supraleitenden Flächen in den Nuten 11, 12 für einen Trim-Laser gut zugänglich sind und somit in einfacher Weise eingeschnitten werden können.

Fig. 2 zeigt die prinzipielle Anordnung eines supraleitenden Drahtes 15 mit nur einer Windung 16 und zwei Anschlußleitungen 17, 18, die zu einer nicht dargestellten Einkoppelspule führen, die auf ein nicht dargestelltes SQUID wirkt. Ein entsprechender Trägerkörper 10 benötigt hierfür nur eine umlaufende Nut 11. Der Pfeil deutet den Wickelsinn an.

Fig. 3 zeigt einen supraleitenden Draht 15, passend für den Trägerkörper 10 nach Fig. 1, mit zwei parallel in Abstand zueinander angeordneten Windungen 16 mit unterschiedlichem Wickelsinn (siehe Pfeile), die über verdrillte Verbindungsleitungen 17, 18 in Reihe geschaltet und mit der nicht dargestellten Einkoppelspule verbunden sind. Die in der Fig. 3 unten dargestellte Windung 16 bildet dabei im wesentlichen die Detektionsspule.

Fig. 4 zeigt einen prinzipiellen Aufbau eines supraleitenden Drahtes 15 mit vier Windungen 16, die über Verbindungsleitungen 17, 18 mit der nicht dargestellten Einkoppelspule in Reihe geschaltet verbunden sind. Bei dieser Anordnung des Drahtes 15 sind die mittleren zwei Windungen in einer in Fig. 1 nicht dargestellten, mittleren umlaufenden Nut 11 angeordnet und die in Fig. 4 unten dargestellte Windung in einer unteren umlaufenden Nut 11 und die in Fig. 4 dargestellte obere Windung 16 in einer oberen umlaufenden Nut 11. Die untere Windung 16 dient dabei der Detektion des zu detektierenden Magnetfeldes und die übrigen Windungen als Kompensationsspulen. Die mittleren Windungen weisen überdies gegenüber den übrigen Windungen einen entgegengesetzten Wickelsinn (siehe Pfeile) auf.

Die in den Fig. 1 bis 4 nur beispielhaft dargestellten Bestandteile des erfindungsgemäßen supraleitenden Gradiometers sind mit einer nicht dargestellten Einkoppelspule und einem nicht dargestellten SQUID verbunden und befinden sich zusammen mit diesen Elementen in einem ebenfalls nicht dargestellten Kryosystem.

## Patentansprüche

1. Supraleitendes Gradiometer zur Messung schwacher Magnetfelder für eine Meßvorrichtung mit einer mit dem Gradiometer verbundenen Einkoppelspule und einem SQUID in einem Kryosystem und einer Auswertevorrichtung, wobei das Gradiometer einen nichtmagnetischen Trägerkörper (10) mit einer Mantelfläche aufweist, die mit mindestens einer umlaufenden Nut (11) versehen ist, die einen supraleitenden Dünnfilm (13) trägt, dadurch gekennzeichnet, daß der Trägerkörper (10) mit mindestens einer an die umlaufende Nut (11) angrenzenden, axial ausgerichteten Nut (12) versehen ist, die ebenfalls den supraleitenden Dünnfilm (13) trägt, und daß die umlaufende Nut (11) mindestens eine supraleitende Drahtwindung (16) und die axial ausgerichtete Nut (12) eine supraleitende Verbindungsleitung vollständig und elektrisch kontaktfrei aufnimmt und daß der umlaufende Dünnfilm (13) unterbrochen ist.

2. Gradiometer nach Anspruch 1,
dadurch gekennzeichnet, daß der supraleitende Draht (15) isoliert ist, und daß mehrere umlaufende Nuten (11) parallel in Abstand zueinander angeordnet sind, jeweils mindestens eine Drahtwindung (16) aufnehmen und über die axiale Nut (12) miteinander in Reihenschaltung verbunden sind.

3. Gradiometer nach Anspruch 2,
dadurch gekennzeichnet, daß jede Drahtwindung (16) und die Verbindungsleitungen in der jeweiligen Nut (11, 12) fixiert, z.B. verklebt ist, und daß die Verbindungsleitungen verdrillt sind und zu einer Einkoppelspule führen.

4. Gradiometer nach Anspruch 3,
dadurch gekennzeichnet, daß als Trägerkörper (10) ein standardisiertes Substrat, z.B. ein zylindrischer Siliziumkristall, verwandt wird.

5. Gradiometer nach Anspruch 4,
dadurch gekennzeichnet, daß jede Nut (11, 12) V-förmigen Querschnitt aufweist und mit einem supraleitenden Dünnfilm (13) aus beispielsweise Niob oder Niobnitrid beschichtet ist, und daß die umlaufenden Nuten (11) einen unbeschichteten Steg (14) aufweisen.

6. Verfahren zur Herstellung eines Gradiometers zur Messung schwacher Magnetfelder für eine Meßvorrichtung mit einer mit dem Gradiometer verbundenen Einkoppelspule und einem SQUID in einem Kryosystem und einer Auswertevorrichtung nach einem oder mehreren der vorhergehenden Ansprüche,
dadurch gekennzeichnet, daß in die Mantelfläche eines nichtmetallischen Trägerkörpers (10) mindestens eine genau bemessene, umlaufende Nut (11) und orthogonal dazu mindestens eine weitere Nut (12) eingeschnitten wird, daß die Mantelfläche und jede Nut (11, 12) ganzflächig mit einem supraleitenden Dünnfilm (13) beschichtet wird, daß der supraleitende Dünnfilm (13) auf der Mantelfläche und im Bereich eines Spaltes (14) in jeder umlaufenden Nut (11) entfernt und anschließend ein isolierter supraleitender, mindestens eine Windung je umlaufende Nut (11) aufweisender Draht (15) in die Nuten (11, 12) eingelegt und darin befestigt wird.

7. Verfahren zur Herstellung eines Gradiometers zur Messung schwacher Magnetfelder für eine Meßvorrichtung mit einer mit dem Gradiometer verbundenen Einkoppelspule und einem SQUID in einem Kryosystem und einer Auswertevorrichtung nach einem oder mehreren der vorhergehenden Ansprüche, durch gekennzeichnet, daß auf die Mantelfläche eines nichtmetallischen Trägerkörpers (10) eine Lackschicht aufgetragen wird und anschließend mindestens eine genau bemessene, umlaufende Nut (11) und orthogonal dazu mindestens eine weitere Nut (12) in die Mantelfläche geschnitten wird, daß die Mantelfläche und jede Nut (11,12) ganzflächig mit einem supraleitenden Dünnfilm (13) beschichtet wird, daß der supraleitende Dünnfilm (13) auf der belackten Mantelfläche durch Eintauchen in ein Lösungsmittel für den Lack entfernt wird, daß der supraleitende Dünnfilm (13) im Bereich eines Spaltes (14) in jeder umlaufenden Nut (11) entfernt und anschließend ein isolierter supraleitender, mindestens eine Windung je umlaufende Nut (11) aufweisender Draht (15) in die Nuten (11,12) eingelegt und darin befestigt wird.

8. Verfahren nach Anspruch 6 oder 7,
dadurch gekennzeichnet, daß jede Nut (11, 12) so tief eingeschnitten wird, daß der oder die supraleitenden Drähte (16; 17, 18) darin vollständig Platz finden.

9. Verfahren nach Anspruch 8,
dadurch gekennzeichnet, daß die Mantelfläche und jede Nut (11, 12) mit einem Elektronenstrahldampf-, Hochfrequenzzerstäubungsverfahren o.dgl. mit Niob, Niobnitrid o.dgl. beschichtet werden.

10. Verfahren nach Anspruch 9,
dadurch gekennzeichnet, daß der Dünnfilm (13) auf der Mantelfäche des Trägerkörpers (10) mit einer Poliereinrichtung o.dgl. entfernt wird.

11. Verfahren nach Anspruch 10,
dadurch gekennzeichnet, daß der Dünnfilm (13) im Bereich des Steges (14) in jeder umlaufenden Nut (11) mit einem Trim-Laser unterbrochen wird.

12. Verfahren nach Anspruch 11,
dadurch gekennzeichnet, daß der Draht (18) verdrillt von einer Einkoppelspule kommend die axiale Nut (12) und eine unterste umlaufende Nut (11) durchläuft, anschließend verdrillt bis zur nächsten umlaufenden Nut (11) zurückgeführt wird, diese gegensinnig mindestens einmal umschließt und anschließend verdrillt bis zur nächsten umlaufenden Nut (11) zurückgeführt wird und diese entsprechend der ersten Nut (11) umschließt, bevor der Draht (18) verdrillt zur Einkoppelspule zurückgeführt wird, und daß der Draht mit der jeweiligen Nut (11,12) verklebt wird.

13. Verfahren nach Anspruch 12,
dadurch gekennzeichnet, daß ein Feinabgleich des nach der Herstellung bereits besser als 10⁻⁴ abgeglichenen Gradiometers durch Veränderung der supraleitenden Flächen in den Nuten (11, 12) mit z.B. einem Trim-Laser durchgeführt wird, und daß mehrere Gradiometer nebeneinander zu einem mehrkanaligen System angeordnet werden.

## Claims

1. A superconductive gradiometer for measuring weak magnetic fields for a measuring device comprising a coupling coil which is connected to the gradiometer and a SQUID in a cryosystem and a processing device, the gradiometer comprising a non-magnetic carrier body (10) having a surface which is provided with at least one circumferential groove (11) which carries a superconductive thin film (13), characterized in that the carrier body (10) is provided with at least one axially oriented groove (12), which adjoins the circumferential groove (11) and which also carries the superconductive thin film (13), and in that the circumferential groove (11) accommodates at least one superconductive wire turn (16) and the axially oriented groove (12) accommodates a superconductive connection wire, both the wire turn and the connection wire being entirely accommodated in said grooves in an electrically contact-free manner, and in that the circumferential thin film (13) is interrupted.

2. A gradiometer as claimed in Claim 1, characterized in that the superconductive wire (15) is insulated and that a number of circumferential grooves (11) are parallel arranged at a distance from each other, each circumferential groove accommodating at least one wire turn (16) and being series connected through the axial groove (12).

3. A gradiometer as claimed in Claim 2, characterized in that each wire turn (16) and the connection wires are fixed, for example using an adhesive, in the respective groove (11, 12), and that the connection wires are twisted and lead to a coupling coil.

4. A gradiometer as claimed in Claim 3, characterized in that a standardized substrate, for example a cylindrical silicon crystal, is used as the carrier body (10).

5. A gradiometer as claimed in Claim 4, characterized in that each groove (11, 12) has a V-shaped cross-section and is coated with a superconductive thin film (13) of, for example, niobium or niobium nitride, and that the circumferential grooves (11) exhibit an uncoated slit (14).

6. A method of manufacturing a gradiometer for measuring weak magnetic fields for a measuring device comprising a coupling coil connected to the gradiometer and a SQUID in a cryosystem and a processing device as claimed in one or several of the preceding Claims, characterized in that at least one accurately dimensioned, circumferential groove (11) and at least one further groove (12) extending orthogonally thereto are cut in the surface of a non-metallic carrier body (10), that the surface and each groove (11, 12) are coated with a superconductive thin film (13) over the entire surface area, that the superconductive thin film (13) is removed from the surface and at the location of a slit (14) formed in each circumferential groove (11), and subsequently an insulated superconductive wire (15) having at least one turn per circumferential groove (11) is introduced and fixed in the grooves (11, 12).

7. A method of manufacturing a gradiometer for measuring weak magnetic fields for a measuring device comprising a coupling coil connected to the gradiometer and a SQUID in a cryosystem and a processing device, as claimed in one or several of the preceding Claims, characterized in that a lacquer layer is applied to the surface of a non-metallic carrier body (10), after which at least one accurately dimensioned, circumferential groove (11) and at least one further groove (12) extending orthogonally thereto are cut in the surface, that the surface and each groove (11, 12) are coated with a superconductive thin film (13) over the entire surface area, that the superconductive thin film (13) on the lacquered surface is removed by immersion in a solvent for the lacquer, that the superconductive thin film (13) is removed at the location of a slit (14) formed in each circumferential groove (11), after which an insulated superconductive wire (15) having at least one turn per circumferential groove (11) is introduced and fixed in the grooves (11, 12).

8. A method as claimed in Claim 6 or 7, characterized in that each groove (11, 12) is cut to such a depth that the superconductive wire(s) (16, 17, 18) are completely accommodated therein.

9. A method as claimed in Claim 8, characterized in that the surface and each groove (11, 12) are coated with niobium, niobium nitride or the like by means of electron beam evaporation, high frequency sputtering or the like.

10. A method as claimed in Claim 9, characterized in that the thin film (13) on the surface of the carrier body (10) is removed by means of, for example, a polishing device.

11. A method as claimed in Claim 10, characterized in that the thin film (13) is interrupted at the location of the slit (14) in each circumferential groove (11) by means of a trimming laser.

12. A method as claimed in Claim 11, characterized in that the wire (18) which is fed forward from a coupling coil in a twisted configuration passes through the axial groove (12) and a lower circumferential groove (11), after which said twisted wire is led back to the next circumferential groove (11) which it surrounds at least once in the opposite direction of winding and, subsequently, the twisted wire is led back to the next circumferential groove (11) which it surrounds in the same manner as the first groove (11), after which the twisted wire (18) is led back to the coupling coil, and in that the wire is fixed in the relevant groove (11, 12) by means of an adhesive.

13. A method as claimed in Claim 12, characterized in that a fine adjustment of the gradiometer having an adjustment value after its manufacture which is already better than 10⁻⁴, is obtained by changing the superconductive surfaces in the groove (11, 12) by means of, for example a trimming laser and that a number of gradiometers are juxtaposed to form a multichannel system.

## Revendications

1. Gradiomètre supraconducteur conçu pour mesurer des champs magnétiques faibles pour un dispositif de mesure comportant une bobine de couplage reliée à un gradiomètre, un SQUID incorporé dans un cryostème et un dispositif de détection, le gradiomètre comportant un support non magnétique (10) ayant une surface dans laquelle est pratiquée au moins une rainure circonférentielle (11) présentant une couche mince supraconductrice (13), caractérisé en ce que le corps (10) présente au moins une rainure contiguë alignée axialement (12) et présentant également la couche mince supraconductrice (13), et en ce que la rainure circonférentielle (11) reçoit complètement et sans contact électrique au moins une spire de fil supraconductrice (16) et que la rainure alignée axialement (12) reçoit complètement et sans contact électrique un fil de connexion supraconducteur, et en ce que la couche mince circonférentielle (13) est interrompue.

2. Gradiomètre selon la revendication 1, caractérisé en ce que le fil supraconducteur (15) est isolé, et en ce que plusieurs rainures circulaires (11) sont pratiquées parallèlement et mutuellement espacées, en ce qu'elles enferment chaque fois au moins une spire de fil (16) et qu'elles sont mutuellement reliées en série par l'intermédiaire de la rainure axiale (12).

3. Gradiomètre selon la revendication 2, caractérisé en ce que chaque spire de fil (16) et les fils de connexion sont fixés respectivement collés dans leur propre ramure (11, 12), et en ce que les fils de connexion sont tordus et qu'ils s'étendent vers une bobine de couplage.

4. Gradiomètre selon la revendication 3, caractérisé en ce que l'on utilise comme support (10) un substrat normalisé, par exemple, un cristal cylindrique de silicium.

5. Gradiomètre selon la revendication 4, caractérisé en ce que chaque rainure (11, 12) présente une coupe transversale en V et qu'elle est revêtue d'une couche mince supraconductrice (13), par exemple, en niobium ou en nitrure de niobium, et en ce que les rainures circulaires (11) présentent une partie (14) non revêtue.

6. Procédé de fabrication d'un gradiomètre pour mesurer des champs magnétiques faibles pour un dispositif de mesure comportant une bobine de couplage reliée à un gradiomètre, un SQUID incorporé dans un cryosystème et un dispositif de détection selon l'une ou plusieurs des revendications précédentes, caractérisé en ce qu'au moins une rainure circonférentielle (11) dimensionnée avec précision et au moins une autre rainure (12) s'étendant de façon orthogonale à ladite rainure (11) sont pratiquées dans la surface circonférentielle d'un support non métallique (10), en ce que la surface circonférentielle et chaque rainure (11, 12) sont revêtues sur toute leur surface d'une couche mince supraconductrice (13), en ce que la couche mince supraconductrice (13) appliquée sur la surface circonférentielle et dans la zone d'une fente (14) pratiquée dans chaque rainure circonférentielle (11) est enlevée et en ce que subséquemment un fil supraconducteur isolé (15) présentant au moins une spire par rainure circonférentielle (11) est posé et fixé dans les rainures (11, 12).

7. Procédé de fabrication d'un gradiomètre pour mesurer des champs magnétiques faibles pour un dispositif de mesure comportant une bobine de couplage reliée à un gradiomètre, un SQUID incorporé dans un cryosystème et un dispositif de détection selon l'une ou plusieurs des revendications précédentes, caractérisé en ce qu'une couche de laque est appliquée sur la surface circonférentielle d'un support non-métallique (10) et que subséquemment au moins une rainure circonférentielle (11) dimensionnée avec précision et au moins une autre rainure (12) s'étendant de façon orthogonale à ladite rainure (11) sont pratiquées dans la surface circonférentielle, en ce que la surface circonférentielle et chaque rainure (11, 12) sont revêtues sur toute leur surface d'une couche mince supraconductrice (13), en ce que la couche mince supraconductrice (13) appliquée sur la surface circonférentielle laquée est enlevée par immersion dans un solvant pour la laque, en ce que la couche mince supraconductrice (13) dans la zone d'une fente (14) pratiquée dans chaque rainure circonférentielle (11) est enlevée et en ce que subséquemment un fil supraconducteur isolé (15) présentant au moins une spire par rainure circonférentielle (11) est posé et fixé dans les rainures (11, 12).

8. Procédé selon la revendication 6 ou 7, caractérisé en ce que chaque rainure (11, 12) présente une profondeur permettant d'y incorporer complètement le(s) fil(s) supraconducteur(s) (16; 17, 18).

9. Procédé selon la revendication 8, caractérisé en ce que la surface circulaire et chaque rainure (11, 12) sont revêtues de niobium, de nitrure de niobium ou des matériaux pareils par la mise en oeuvre d'un procédé d'évaporation par faisceau électronique ou par pulvérisation à haute fréquence ou par des procédés pareils.

10. Procédé selon la revendication 9, caractérisé en ce que la couche mince (13) appliquée sur la surface du support (10) est enlevée à l'aide d'un dispositif de polissage ou un dispositif pareil.

11. Procédé selon la revendication 10, caractérisé en ce que la couche mince (13) dans la zone de la partie (14) prévue dans chaque rainure circulaire (11) est interrompue à l'aide d'un laser-trimmer.

12. Procédé selon la revendication 11, caractérisé en ce que le fil (18) provenant de façon tordue d'une bobine de couplage parcourt la rainure axiale (12) et une rainure circulaire inférieure (11), en ce que, subséquemment, il est ramené de façon tordue à la rainure circulaire suivante (11) pour l'entourer au moins une fois en direction opposée, et en ce que, subséquemment, il est ramené de façon tordue à la rainure circulaire suivante (11) pour l'entourer conformément à la première rainure (11), avant que le fil 18 ne soit ramené de façon tordue à la bobine de couplage pour être collé dans la propre rainure (11, 12).

13. Procédé selon la revendication 12, caractérisé en ce qu'un ajustage de précision du gradiomètre présentant déjà dès sa fabrication un ajustage meilleur que 10⁻⁴ peut être effectué en changeant les surfaces supraconductrices des rainures (11, 12), par exemple, à l'aide d'un laser trimmer et en ce que plusieurs gradiomètres sont juxtaposés de manière à constituer un système à canaux multiples.
